# EUROPEAN PATENT APPLICATION

(11) **EP 4 529 401 A1**
(43) Date of publication of application: **26.03.2025**
(21) Application number: 23807912.3
(22) Date of filing: 17.05.2023
(51) Int. Cl.: H10K 59/38, H10K 71/50, H10K 50/844, H10K 50/856, H10K 50/115, H10K 59/10, H10K 102/00

(54) **DISPLAY DEVICE**

(30) Priority: 17.05.2022 KR 20220060452; 03.06.2022 KR 20220068504
(71) Applicant: Samsung Display Co., Ltd., Yongin-si, Gyeonggi-do 17113 (KR)
(72) Inventor: YOON, Seon Tae, Yongin-si Gyeonggi-do 17113 (KR); KWON, Jung Hyun, Yongin-si Gyeonggi-do 17113 (KR); KIM, Hyun Seok, Yongin-si Gyeonggi-do 17113 (KR); KIM, Hyo Joon, Yongin-si Gyeonggi-do 17113 (KR); LEE, Hye Seung, Yongin-si Gyeonggi-do 17113 (KR); CHA, Soon Kyu, Yongin-si Gyeonggi-do 17113 (KR)
(74) Representative: Marks & Clerk LLP
(86) International application number: PCT/KR2023/006713
(87) International publication number: WO 2023/224393

(57) **Abstract**

A display device includes: a first substrate; a second substrate; a light-emitting element layer on the first substrate and comprising at least one light-emitting element; an encapsulation layer on the light-emitting element layer and comprising at least one inorganic encapsulation layer and at least one organic encapsulation layer; a color conversion-transmitting layer on the encapsulation layer and configured to convert light emitted from the at least one light-emitting element into light having different colors, the color conversion-transmitting layer including quantum dots; a low-refractive inorganic layer on the color conversion-transmitting layer and having a refractive index less than a refractive index of the color conversion-transmitting layer; a color filter layer on a surface of the second substrate opposite to the first substrate; and a filler between the low-refractive inorganic layer and the color filter layer and having a refractive index greater than the refractive index of the low-refractive inorganic layer.

## Description

### TECHNICAL FIELD

Aspects of some embodiments of the present disclosure relate to a display device.

### BACKGROUND ART

Due to the rapid development of the field of displays for visually expressing various electrical signal information, various display devices having extraordinary characteristics such as small thickness, small weight, and low power consumption have been introduced.

Display devices may include liquid display devices using light from backlight units without independently emitting light or light-emitting display devices including display elements capable of emitting light. Light-emitting display devices may include display elements including emission layers.

### DETAILED DESCRIPTION OF INVENTION

### TECHNICAL PROBLEM

A technical goal of the present invention is to provide a high-efficiency display device. However, the technical goal is merely an example and should not be construed as limiting the scope of the present invention.

### SOLUTION TO PROBLEM

According to one or more embodiments, a display device includes a first substrate, a second substrate opposite to the first substrate, a light-emitting element layer on the first substrate and including at least one light-emitting element, an encapsulation layer on the light-emitting element layer and including at least one inorganic encapsulation layer and at least one organic encapsulation layer, a color conversion-transmitting layer on the encapsulation layer and configured to convert light emitted from the at least one light-emitting element into light having different colors, the color conversion-transmitting layer including quantum dots, a low-refractive inorganic layer on the color conversion-transmitting layer and having a refractive index less than a refractive index of the color conversion-transmitting layer, a color filter layer on a surface of the second substrate opposite to the first substrate, and a filler between the low-refractive inorganic layer and the color filter layer and having a refractive index greater than a refractive index of the low-refractive inorganic layer.

According to some embodiments, the refractive index of the low-refractive inorganic layer may be greater than 1.2 and less than 1.4.

According to some embodiments, the low-refractive inorganic layer may include silicon oxide (SiO₂).

According to some embodiments, a thickness of the low-refractive inorganic layer may be from about 100 Å to about 4,000 Å.

According to some embodiments, a difference between the refractive index of the color conversion-transmitting layer and the refractive index of the low-refractive inorganic layer may be at least 0.3.

According to some embodiments, the display device may further include a first passivation layer between the color conversion-transmitting layer and the filler, the first passivation layer having a refractive index greater than the refractive index of the low-refractive inorganic layer.

According to some embodiments, the low-refractive inorganic layer and the color conversion-transmitting layer may be sequentially on the color conversion-transmitting layer.

According to some embodiments, the color conversion-transmitting layer and the low-refractive inorganic layer may be sequentially on the color conversion-transmitting layer.

According to some embodiments, the first passivation layer may include silicon oxynitride (SiON).

According to some embodiments, the refractive index of the filler may be from about 1.45 to about 1.55, and a thickness of the filler may be from about 1 µm to about 10 µm.

According to some embodiments, the encapsulation layer may include a first inorganic encapsulation layer, an organic encapsulation layer, and a second inorganic encapsulation layer sequentially arranged, and the color conversion-transmitting layer may directly contact the second inorganic encapsulation layer.

According to some embodiments, the display device may further include a low-refractive organic layer and a second passivation layer on a surface of the color filter layer opposite to the color conversion-transmitting layer.

According to some embodiments, the low-refractive organic layer may include an organic material and porous particles dispersed in the organic material.

According to some embodiments, the low-refractive inorganic layer may have a coefficient of extinction less than a coefficient of extinction of the low-refractive organic layer.

According to some embodiments, a refractive index of the low-refractive organic layer may be less than the refractive index of the low-refractive inorganic layer.

According to some embodiments, the second passivation layer may include SiO₂ and may have a refractive index greater than the refractive index of the low-refractive inorganic layer.

According to some embodiments, the color filter layer includes a first color filter configured to transmit light of a first color, a second color filter configured to transmit light of a second color, a third color filter configured to transmit light of a third color, and a light-blocking portion dividing the first color filter, the second color filter, and the third color filter, and the light-blocking portion may be formed by overlapping a first color layer, a second color layer, and a third color layer respectively arranged on same layers as the first color filter, the second color filter, and the third color filter.

According to some embodiments, the light-emitting element layer may include a first light-emitting element, a second light-emitting element, and a third light-emitting element, and the color conversion-transmitting layer may include a first color converter corresponding to the first light-emitting element, a second color converter corresponding to the second light-emitting element, and a transmitter corresponding to the third light-emitting element, and may further include a light-blocking partition wall arranged among the first color converter, the second color converter, and the transmitter.

According to some embodiments, a top surface of each of the first color converter, the second color converter, and the transmitter may have a concave shape recessed with respect to a top surface of the light-blocking partition wall, and the low-refractive inorganic layer may include a groove formed according to the concave shape.

According to some embodiments, the first substrate and the second substrate may each include glass.

According to one or more embodiments, a display device includes a first substrate, a second substrate opposite to the first substrate, a light-emitting element layer on the first substrate and including at least one light-emitting element, an encapsulation layer on the light-emitting layer and including at least one inorganic encapsulation layer and at least one organic encapsulation layer, a color conversion-transmitting layer on the encapsulation layer and configured to convert light emitted from the at least one light-emitting element into light having different colors, the color conversion-transmitting layer including quantum dots, a low-refractive inorganic layer on the color conversion-transmitting layer and having a refractive index less than a refractive index of the color conversion-transmitting layer, and a color filter layer on a surface of the second substrate opposite to the first substrate, and being apart from the low-refractive inorganic layer with an air gap therebetween.

According to some embodiments, the refractive index of the low-refractive inorganic layer may be greater than 1.2 and less than 1.4, and a thickness of the low-refractive inorganic layer may be from about 100 Å to about 4,000 Å.

According to some embodiments, a difference between the refractive index of the color conversion-transmitting layer and the refractive index of the low-refractive inorganic layer may be at least 0.3.

According to some embodiments, the color filter layer may include a first color filter configured to transmit light of a first color, a second color filter configured to transmit light of a second color, a third color filter configured to transmit light of a third color, and a light-blocking portion dividing the first color filter, the second color filter, and the third color filter, and in the light-blocking portion, a first color layer, a second color layer, and a third color layer respectively including same materials as the first color filter, the second color filter, and the third color filter overlap.

According to some embodiments, the light-emitting element layer may include a first light-emitting element, a second light-emitting element, and a third light-emitting element, and the color conversion-transmitting layer may include a first color converter corresponding to the first light-emitting element, a second color converter corresponding to the second light-emitting element, and a transmitter corresponding to the third light-emitting element, and the display device further includes a light-blocking partition wall arranged among the first color converter, the second color converter, and the transmitter, a top surface of each of the first color converter, the second color converter, and the transmitter may have a concave shape recessed with respect to a top surface of the light-blocking partition wall, and the low-refractive inorganic layer may include a groove formed according to the concave shape.

Aspects, features, and characteristics in addition to the descriptions will be clearly understood from detailed descriptions, claims, and accompanying drawings.

### ADVANTAGEOUS EFFECTS OF DISCLOSURE

According to the embodiments described above, a display device with relatively high efficiency may be provided. However, the scope of the disclosure is not limited thereto.

### BRIEF DESCRIPTION OF THE DRAWINGS

FIG. 1 is a schematic perspective view of a display device according to some embodiments;
FIG. 2A is a schematic cross-sectional view of a display device according to some embodiments;
FIG. 2B is a schematic cross-sectional view of a pixel of a display device according to some embodiments;
FIG. 3 illustrates a color converter and transmitter of a color conversion-transmission layer shown in FIG. 2B;
FIG. 4 is an equivalent circuit diagram of a light-emitting element included in a display device according to some embodiments and a pixel circuit electrically connected to the light-emitting element;
FIGS. 5 and 6 are cross-sectional views for explaining a method of manufacturing an light-emitting panel according to some embodiments;
FIGS. 7 to 9 are cross-sectional views for explaining a method of manufacturing a color filter panel according to some embodiments;
FIG. 10A is a schematic cross-sectional view of a display device according to some embodiments, the display device including the light-emitting panel and the color filter panel respectively shown in FIGS. 6 and 9;
FIG. 10B is a cross-sectional view of a portion of FIG. 10A to describe principles of improvement in light efficiency;
FIG. 11 is a schematic cross-sectional view of a display device according to some embodiments;
FIG. 12A is a schematic cross-sectional view of a display device according to some embodiments;
FIG. 12B is a cross-sectional view of a portion of FIG. 12A to describe principles of improvement in light efficiency;
FIG. 13 is a schematic cross-sectional view of a display device according to some embodiments; and
FIG. 14 is a schematic cross-sectional view of a display device according to some embodiments.

### BEST MODE OF DISCLOSURE

An embodiment of the present invention provides a display device including a light-emitting element layer on the first substrate and including at least one light-emitting element, an encapsulation layer on the light-emitting element layer and including at least one inorganic encapsulation layer and at least one organic encapsulation layer, a color conversion-transmitting layer on the encapsulation layer and configured to convert light emitted from the at least one light-emitting element into light having different colors, the color conversion-transmitting layer including quantum dots, a low-refractive inorganic layer on the color conversion-transmitting layer and having a refractive index less than a refractive index of the color conversion-transmitting layer, a color filter layer on a surface of the second substrate opposite to the first substrate, and a filler between the low-refractive inorganic layer and the color filter layer and having a refractive index greater than a refractive index of the low-refractive inorganic layer.

### MODE OF DISCLOSURE

As the disclosure allows various modifications and may have various embodiments, specific embodiments will be shown in the drawings and described in more detail below. Effects and characteristics of the disclosure, and methods of achieving the same will be clearly understood with reference to embodiments described in more detail in conjunction with the accompanying drawings. However, the disclosure is not limited to the embodiments disclosed hereinafter and may be embodied in different forms.

Hereinafter, aspects of some embodiments will be described in more detail with reference to the accompanying drawings, and in descriptions with reference to the drawings, same reference numbers will be given to same or corresponding components, and same descriptions thereof will be omitted.

In the following embodiments, terms such as first, second are only used to distinguish one component from others, not in a limiting sense.

In following embodiments, an expression used in the singular encompasses the expression of the plural, unless it has a clearly different meaning in the context.

In following embodiments, terms such as "include" or "comprise" indicate the existence of the features or components disclosed in the specification, and are not intended to preclude the possibility that one or more other features or components may be added.

In following embodiments, it will be understood that when a component such as a layer, a film, an area, or a plate is referred to as being "on" another component, the component may be directly on the other component or intervening components may be present thereon. Sizes of components in the drawings may be exaggerated or reduced for convenience of explanation. For example, sizes and thicknesses of the components in the drawing are arbitrarily illustrated for convenience of explanation, and therefore, the embodiments are not limited to the illustration.

When an embodiment may be implemented differently, a specific process order may be performed differently from the described order. For example, two consecutively described processes may be performed substantially at the same time or performed in an order opposite to the described order.

In following embodiments, when it is referred that a components such as layers, films, areas, and plates are connected with each other, the components may be directly connected with each other or may be indirectly connected with other with intervening other components. For example, when components are electrically connected with each other, the components may be directly connected with each other, or may be indirectly connected with each other with other intervening components.

In the following examples, the x-axis, the y-axis and the z-axis are not limited to three axes of the rectangular coordinate system, and may be interpreted in a broader sense. For example, the x-axis, the y-axis, and the z-axis may be perpendicular to one another, or may represent different directions that are not perpendicular to one another.

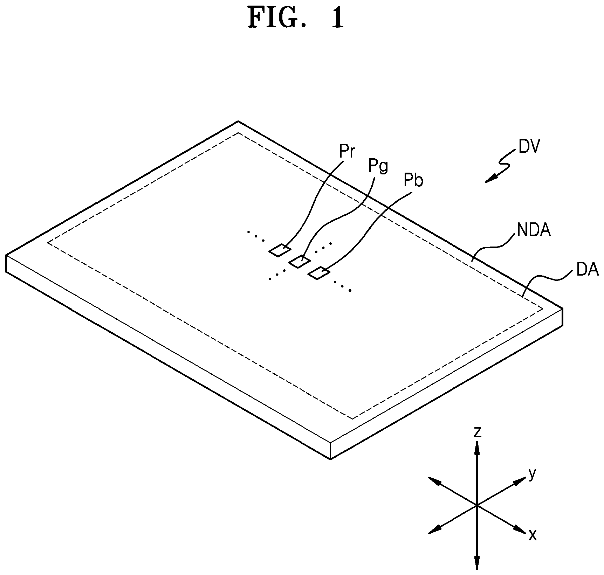

FIG. 1 is a schematic perspective view of a display device according to some embodiments.

Referring to FIG. 1, a display device DV may include a display area DA and a non-display area NDA. The display device DV may display images through an array of a plurality of pixels two-dimensionally arranged on an x-y plane in the display area DA. The plurality of pixels include a first pixel, a second pixel, and a third pixel. Hereinafter, for convenience of explanation, a case in which the first pixel includes a red pixel Pr, the second pixel includes a green pixel Pg, and the third pixel includes a blue pixel Pb will be described.

The non-display area NDA may surround at least a portion of the display area DA. According to some embodiments, the non-display area NDA may surround the entire portion of the display area DA. For example, the non-display area NDA may be located in a periphery (or outside a footprint) of the display area DA. The non-display area NDA may include an area in which images are not displayed. A driver or a main power line configured to provide electric signals or power to pixel circuits may be arranged in the non-display area NDA. The non-display area NDA may include a pad area, that is, an area to which electronic devices or a printed circuit board may be electrically connected.

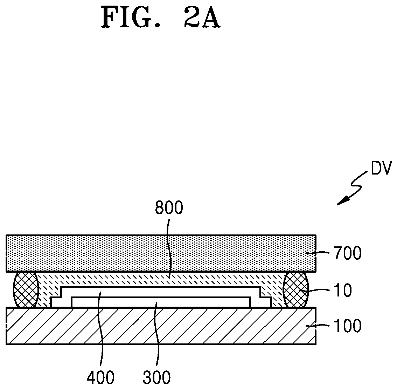

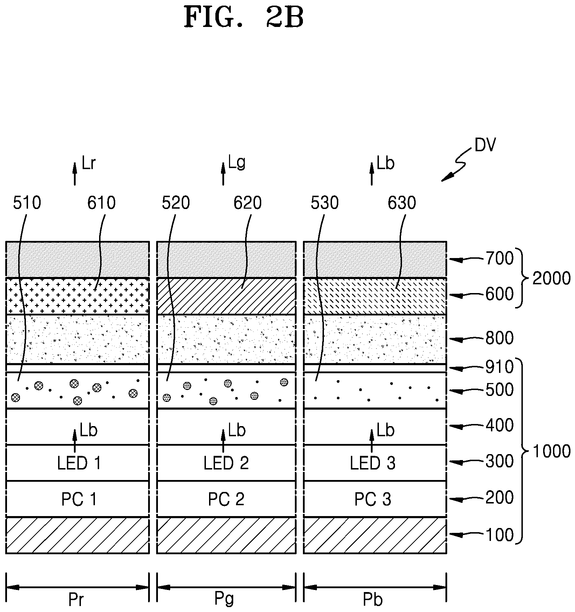

FIG. 1 illustrates that the display area DA has a rectangular shape. However, the disclosure is not limited thereto. The display area DA may have various shapes, for example, circle, oval, polygon, or shapes of certain figures. According to some embodiments, the display device DV may include a light-emitting panel 1000 (see FIG. 2B) and a color filter panel 2000 (see FIG. 2B) apart from each other in a thickness direction (for example, the z direction) with a filler 800 (see FIG. 2) therebetween.

FIG. 2A is a schematic cross-sectional view of the display device according to some embodiments, and FIG. 2B is a schematic cross-sectional view of a pixel of the display device according to some embodiments.

Referring to FIG. 2A, the display device DV may include a first substrate 100 and a second substrate 700 opposite to each other, and a light-emitting element layer 300 including a plurality of light-emitting elements and a thin-film encapsulation layer 400 encapsulating the light-emitting element layer 300 may be located on the first substrate 100.

Referring to FIG. 2B, the display device DV includes the light-emitting panel 1000 and the color filter panel 2000 apart from each other with the filler 800 therebetween.

The light-emitting panel 1000 may include a circuit layer 200, the light-emitting element layer 300, the encapsulation layer 400, and the color conversion-transmitting layer 500 sequentially stacked on the first substrate 100. The circuit layer 200 may include a first pixel circuit PC1, a second pixel circuit PC2, and a third pixel circuit PC3, which may be electrically connected to a first light-emitting element LED1, a second light-emitting element LED2, and a third light-emitting element LED3 of the light-emitting element layer 300, respectively.

The first light-emitting element LED1, the second light-emitting element LED2, and the third light-emitting element LED3 may include organic light-emitting diodes including organic materials. According to some embodiments, the first light-emitting element LED1, the second light-emitting element LED2, and the third light-emitting element LED3 may include inorganic light-emitting diodes including inorganic materials. The inorganic light-emitting diode may include a PN junction diode including inorganic semiconductor-based materials. When a voltage is applied in a positive direction to the PN junction diode, holes and electrons are injected into the PN junction diode, and energy generated by recombination of the holes and electrons may be converted into light energy to emit light having a certain color. The inorganic light-emitting diode may have a width of about several to hundreds of micrometers or several to hundreds of nanometers. In some embodiments, the first light-emitting element LED1, the second light-emitting element LED2, and the third light-emitting diode LED3 may include light-emitting diodes including quantum dots. As described above, emission layers of the first light-emitting element LED1, the second light-emitting element LED2, and the third light-emitting element LED3 may include an organic material, an inorganic material, quantum dots, an organic material and quantum dots, or an inorganic material and quantum dots.

The first light-emitting element LED1, the second light-emitting element LED2, and the third light-emitting element LED3 may emit light having a same color. For example, light (for example, the blue light Lb) emitted from the first light-emitting element LED1, the second light-emitting element LED2, and the third light-emitting element LED3 may be transmitted through the encapsulation layer 400 on the light-emitting element layer 300 and incident to the color conversion-transmitting layer 500.

The color conversion-transmitting layer 500 may be located on the encapsulation layer 400 to directly contact the encapsulation layer 400. The color conversion-transmitting layer 500 may include color converters configured to convert the light (for example, the blue light Lb) into light having different colors, and a transmitter configured to transmit the light (for example, the blue light Lb), which is emitted from the light-emitting element layer 300, without color conversion. For example, the color conversion-transmitting layer 500 may include a first color converter 510 corresponding to the red pixel Pr, a second color converter 520 corresponding to the green pixel Pg, and a transmitter 530 corresponding to the blue pixel Pb. The first color converter 510 may convert the blue light Lb into red light Lr, and the second color converter 520 may convert the blue light Lb into green light Lg. The transmitter 530 may transmit the blue light Lb without conversion.

According to some embodiments, the color conversion-transmitting layer 500 may be formed above the first substrate 100, not above the second substrate 700. By this configuration, a distance between the first light-emitting element LED1, the second light-emitting element LED2, and the third light-emitting element LED3 may be reduced, and loss of light in a path may be reduced as much as possible to improve light efficiency.

The color filter panel 2000 may include a color filter layer 600 located on a surface of the second substrate 700 facing the first substrate 100. The color filter layer 600 may be arranged opposite to the color conversion-transmitting layer 500 with the filler 800 therebetween. The color filter layer 600 may include a first color filter 610, a second color filter 620, and a third color filter 630 respectively having different colors. For example, the first color filter 610, the second color filter 620, and the third color filter 630 may include color filters configured to transmit red light, green light, and blue light, respectively.

Color purities of lights color-converted and transmitted by the color conversion-transmitting layer 500 may be improved by the first color filter 610, the second color filter 620, and the third color filter 630. In addition, the color filter layer 600 may prevent or minimize external light (for example, light incident on the display device DV from outside the display device DV) from being reflected and recognized by a user.

The filler 800 may be located between the color conversion-transmitting layer 500 and the color filter layer 600. The filler 800 may bond the light-emitting panel 1000 (see FIG. 2B) and the color filter panel 2000 (see FIG. 2B) by a sealant 10 (see FIG. 2A) and may fill a space between the light-emitting panel 1000 and the color filter panel 2000. The filler 800 may include a light-transmitting material, for example, an acryl resin or epoxy resin. According to some embodiments, a refractive index of the filler 800 may be from about 1.45 to about 1.55.

According to some embodiments, a low-refractive inorganic layer 910 may be located on the color conversion-transmitting layer 500. That is, the low-refractive inorganic layer 910 may be located between the color conversion-transmitting layer 500 and the filler 800.

The low-refractive inorganic layer 910 may have a refractive index greater than 1.2 and less than 1.4, and may include, for example, silicon oxide (SiO₂). Although a refractive index of the silicon oxide is generally less than other inorganic layers, the refractive index of the silicon oxide is from about 1.45 to about 1.5. According to some embodiments, the low-refractive inorganic layer 910 having the refractive index greater than 1.2 and less than 1.4 may be implemented by forming the silicon oxide specifically under a process condition under which a refractive index may be low. Functions of the low-refractive inorganic layer 910 will be described later.

The display device DV having the aforementioned structure may include various devices such as a smartphone, a tablet, a laptop, a television, or a billboard.

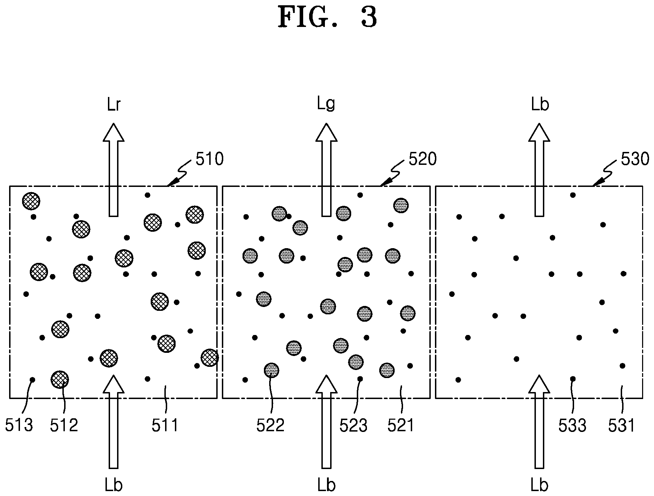

FIG. 3 illustrates a color converter and transmitter of a color conversion-transmission layer shown in FIG. 2B.

Referring to FIG. 3, the first color converter 510 may convert the blue light Lb, which is incident to the first color converter 510, into the red light Lr. The first color converter 510 may include a first photosensitive polymer 511, and first quantum dots 512 and first scattering particles 513 dispersed in the first photosensitive polymer 511.

The first quantum dots 512 may be excited by the blue light Lb to emit the red light Lr having a wavelength greater than a wavelength of the blue light Lb. The first photosensitive polymer 511 may include an organic material having light transmissivity.

The first scattering particles 513 may scatter the blue light Lb that has not been absorbed by the first quantum dots 512 to excite more of the first quantum dots 512, thereby increasing the efficiency of color conversion. The first scattering particles 513 may include, for example, titanium dioxide (TiO2) particles or metal particles. The first quantum dots 512 may be selected from among a Group II-VI compound, a Group III-V compound, a Group IV-VI compound, a Group IV element, a Group IV compound, and combinations thereof.

The Group II-VI compound may be selected from a group consisting of: a two-element compound selected from a group consisting of CdSe, CdTe, ZnS, ZnSe, ZnTe, ZnO, HgS, HgSe, HgTe, MgSe, MgS and combinations thereof; a three-element compound selected from a group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and combinations thereof; and a four-element compound selected from a group consisting of HgZnTeS, CdZnSeS, CdZnSeTe, CdZnSTe, CdHgSeS, CdHgSeTe,CdHgSTe, HgZnSeS, HgZnSeTe, HgZnSTe, and combinations thereof.

The Group III-VI compound may include a two-element compound such as In₂S₃, In₂Se₃; a three-element such as InGaSe, InGaSe₃; and an arbitrary combination thereof.

The Group III-V compound may be selected from a group consisting of: a two-element compound selected from a group consisting of GaN, GaP, GaAs, GaSb, AIN, AlP, AlAs, AlSb, InN, InP, InAs, InSb, and combinations thereof; a three-element compound selected from a group consisting of GaNP, GaNAs, GaNSb, GaPAs, GaPSb, AINP, AlNAs, AlNSb, AlPAs,AlPSb, InNP, InAlP, InNAs, InNSb, InPAs, InPSb, GaAlNP, and combinations thereof; and a four-element compound selected from a group consisting of GaAINAs, GaAINSb, GaAlPAs, GaAlPSb, GaInNP, GaInNAs, GaInNSb, GaInPAs, GaInPSb, InAlNP, InAINAs, InAINSb, InAlPAs, InAlPSb, and combinations thereof. The Group III-V semiconductor compound may further include a Group II metal (for example, InZnP).

The Group IV-VI compound may be selected from a group consisting of: a two-element compound selected from a group consisting of SnS, SnSe, SnTe, PbS, PbSe, PbTe, and combinations thereof; a three-element compound selected from a group consisting of SnSeS, SnSeTe, SnSTe, PbSeS, PbSeTe, PbSTe, SnPbS, SnPbSe, SnPbTe, and combinations thereof; and a four-element compound selected from a group consisting of SnPbSSe, SnPbSeTe, SnPbSTe, and combinations thereof. The Group IV element may be selected from a group consisting of Si, Ge, and a combination thereof. The Group IV compound may include a two-element compound selected from a group consisting of SiC, SiGe, and a combination thereof.

The second color converter 520 may convert the blue light Lb, which is incident to the second color converter 520, into the green light Lg. The second color converter 520 may include a second photosensitive polymer 521, second quantum dots 522, and second scattering particles 523 dispersed in the second photosensitive polymer 521.

The second quantum dots 522 may be excited by the blue light Lb to emit the green light Lg having a wavelength greater than a wavelength of the blue light Lb. The second photosensitive polymer 521 may include an organic material having light transmissivity.

The second scattering particles 523 may scatter the blue light Lb that has not been absorbed by the second quantum dots 522 to excite more of the second quantum dots 522, thereby increasing the efficiency of color conversion. The second scattering particles 523 may include, for example, titanium dioxide (TiO₂) particles or metal particles. The second quantum dots 522 may be selected from among the Group II-VI compound, the Group III-V compound, the Group IV-VI compound, the Group IV element, the Group IV compound, and combinations thereof.

In some embodiments, the first quantum dots 512 and the second quantum dots 522 may include a same material. In this case, a size of the first quantum dots 512 may be greater than a size of the second quantum dots 522.

The transmitter 530 may transmit the blue light Lb, which is incident to the transmitter 530, without conversion. The transmitter 530 may include a third photosensitive polymer 531 in which third scattering particles 533 are dispersed. The third photosensitive polymer 531 may include, for example, an organic material having light transmissivity such as silicon resin and epoxy resin, and may include a same material as those of the first photosensitive polymer 511 and the second photosensitive polymer 521. The third scattering particles 533 may scatter and emit the blue light Lb, and may include a same material as those of the first scattering particles 513 and the second scattering particles 523.

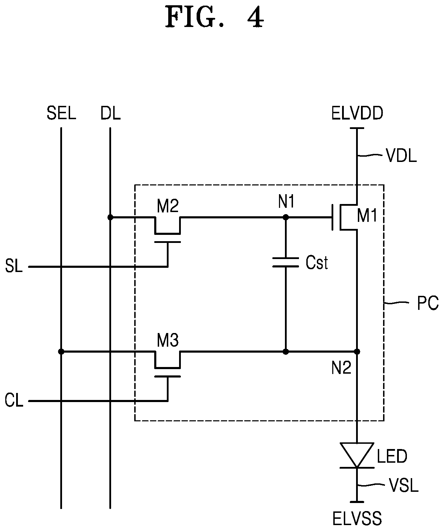

FIG. 4 is an equivalent circuit diagram of a light-emitting element included in a display device according to some embodiments and a pixel circuit electrically connected to the light-emitting element.

Referring to FIG. 4, a pixel electrode (for example, an anode) of the light-emitting element LED is electrically connected to the pixel circuit PC, and an opposite electrode (for example, a cathode) of the light-emitting element LED may be connected to a common voltage line VSL configured to provide a common power voltage ELVSS. The light-emitting element LED may emit light at a luminance corresponding to an amount of current provided from the pixel circuit PC.

The light-emitting element LED shown in FIG. 4 may correspond to each of the first light-emitting element LED1, the second light-emitting element LED2, and the third light-emitting element LED3 shown in FIG. 2B, and the pixel circuit PC shown in FIG. 4 may correspond to each of the first pixel circuit PC1, the second pixel circuit PC2, and the third pixel circuit PC3 shown in FIG. 2B.

The pixel circuit PC may control an amount of current flowing from the driving power voltage ELVDD to the common power voltage ELVSS via the light-emitting element LED, in response to a data signal. The pixel circuit PC may include a first transistor M1, a second transistor M2, a third transistor M3, and a storage capacitor Cst.

Each of the first transistor M1, the second transistor M2, and the third transistor M3 may include an oxide semiconductor thin-film transistor including a semiconductor layer including an oxide semiconductor, or may include a silicon semiconductor thin-film transistor including a semiconductor layer including polysilicon. The transistor may include a first electrode and a second electrode. According to the type of the transistor, the first electrode may include one of a source electrode and a drain electrode, and the second electrode may include another one of the source electrode and the drain electrode.

The first transistor M1 may include a driving transistor. A first electrode of the first transistor M1 is electrically connected to the driving power line VDL configured to provide the drive power voltage ELVDD, and the second electrode may be electrically connected to a pixel electrode of the light-emitting element LED. A gate electrode of the first transistor M1 may be electrically connected to the first node N1. The first transistor M1 may control an amount of current flowing from the driving power voltage ELVDD to the light-emitting element LED, in response to a voltage of the first node N1.

The second transistor M2 may include a switching transistor. A first electrode of the second transistor M2 may be electrically connected to a data line DL, and the second electrode may be electrically connected to the first node N1. A gate electrode of the second transistor M2 may be electrically connected to a scan line SL. The second transistor M2 may be turned on when a scan signal is provided to the scan line SL to electrically connect the data line DL with the first node N1.

The third transistor M3 may include an initialization transistor and/or a sensing transistor. A first electrode of the third transistor M3 may be electrically connected to the second node N2, and a second electrode may be connected to a sensing line SEL. A gate electrode of the third transistor M3 may be electrically connected to a control line CL.

The third transistor T3 may be turned on when a control signal is provided to the control line CL, to electrically connect the sensing line SEL with the second node N2. In some embodiments, the third transistor T3 may be turned on in response to a signal received through the control line CL, and may transmit an initialization voltage from the sensing line SEL to the light-emitting element LED to initialize a pixel electrode. In some embodiments, the third transistor T3 may be turned on when the control signal is provided to the control line CL, to sense characteristic information of the light-emitting element LED. The third transistor T3 may have any one or both of a function as the initialization transistor and a function as the sensing transistor described above. In some embodiments, when the third transistor T3 has the function as the initialization transistor, the sensing line SEL may be named as an initialization voltage line. An initialization operation and a sensing operation of the third transistor T3 may be individually performed, or may be simultaneously performed.

The storage capacitor Cst may be connected between the first node N1 and the second node N2. For example, a first capacitor electrode of the storage capacitor Cst may be electrically connected to the gate electrode of the first transistor M1, and a second capacitor of the storage capacitor Cst may be electrically connected to the pixel electrode of the light-emitting element LED.

Although FIG. 4 illustrates the first transistor M1, the second transistor M2, and the third transistor M3 include an N-type metal oxide semiconductor (NMOS), in other embodiments, at least one of the first transistor T1, the second transistor T2, or the third transistor T3 may include a P-type metal oxide semiconductor (PMOS).

Although FIG. 4 illustrates three transistors, in other embodiments, the pixel circuit PC may include four or more transistors.

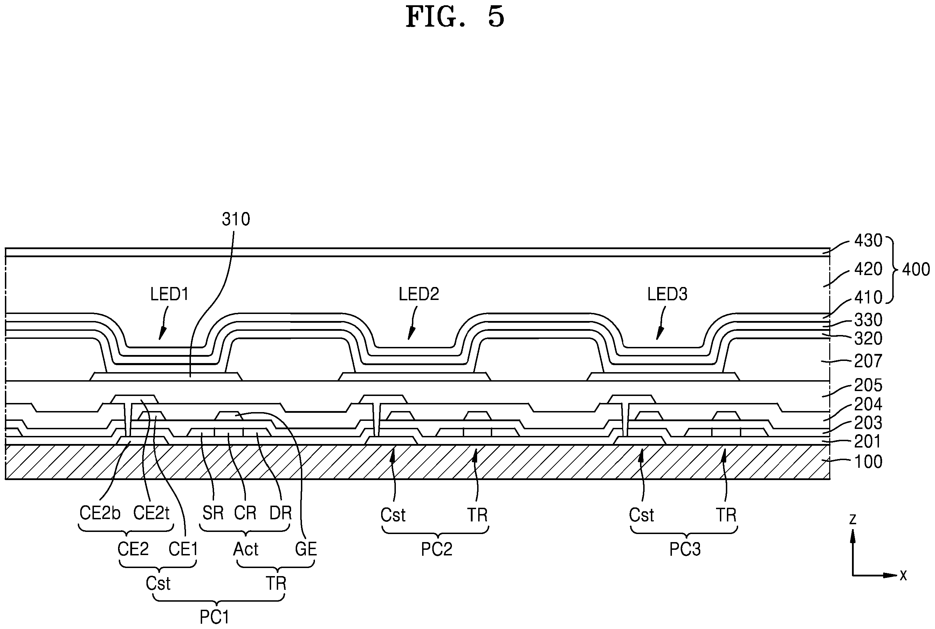

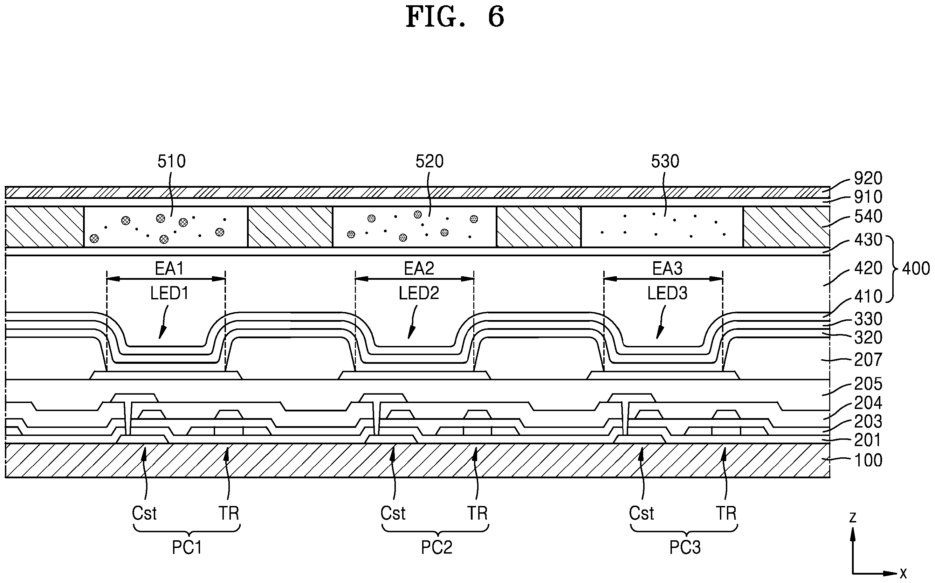

FIGS. 5 and 6 are cross-sectional views of a method of manufacturing a light-emitting panel according to some embodiments. Hereinafter, a case in which the light-emitting element includes an organic light-emitting element is described.

Referring to FIG. 5, the first pixel circuit PC1, the second pixel circuit PC2, and the third pixel circuit PC3 are formed on the first substrate 100. The first substrate 100 may include a glass substrate having SiO₂ as a main component. The glass substrate may include, for example, a glass substrate having a thickness of about 500 µm, or may include an ultra-thin glass substrate having a thickness of about 30 µm. According to some embodiments, the first substrate 100 may include a polymer resin. The first substrate 100 including the polymer resin may be flexible, foldable, rollable, or bendable. According to some embodiments, the first substrate 100 may have a multi-layer structure including a layer including a polymer resin and an inorganic layer.

As described above with reference to FIG. 4, each of the first pixel circuit PC1, the second pixel circuit PC2, and the third pixel circuit PC3 includes a first transistor, a second transistor, a third transistor, and a storage capacitor. In this regard, FIG. 5 illustrates a transistor TR, which is any one of the first transistor, the second transistor, and the third transistor, and a storage capacitor Cst.

According to some embodiments, the storage capacitor Cst may include a first capacitor electrode CE1 and a second capacitor electrode CE2, and the second capacitor electrode CE2 may include a first sub-capacitor electrode CE2b and a second sub-capacitor electrode CE2t, respectively formed above and under the first capacitor electrode CE1.

The first sub-capacitor electrode CE2b may be directly formed on the first substrate 100. For example, the first sub-capacitor electrode CE2b may directly contact a top surface of the first substrate 100. The first sub-capacitor electrode CE2b may include a conductive material, such as aluminium (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), and/or copper (Cu). According to some embodiments, the driving voltage line VDL, the common voltage line VSL, and/or the data line DL may be formed together with the first sub-capacitor electrode CE2b in a same process.

Next, a buffer layer 201 may be formed. The buffer layer 201 may be located above the second sub-capacitor electrode CE2t, and may include an inorganic insulating material. The buffer layer 201 may include an inorganic insulating material such as silicon nitride, silicon oxide, and/or silicon oxynitride, and may include a single-layer structure or multi-layer structure including the aforementioned materials.

Next, a semiconductor layer Act of the transistor TR may be formed. The semiconductor layer Act may include an oxide semiconductor material such as IGZO, amorphous silicon, polycrystalline silicon, or an organic semiconductor material.

A gate insulating layer 203 may be formed on the semiconductor layer Act. The gate insulating layer 203 may include an inorganic insulating material such as silicon nitride, silicon oxynitride, and may include a single-layer structure or multi-layer structure including the aforementioned materials.

The gate electrode GE may be formed on the gate insulating layer 203 and overlap a portion of the semiconductor layer Act. The gate electrode GE may overlap a channel region CR of the semiconductor layer Act, and the semiconductor layer Act may include the channel region CR, and a source region SR and a drain region DR respectively arranged at two sides of the channel region CR.

The first capacitor electrode CE1 may be formed on a same layer and include same material as the gate electrode GE. The first capacitor electrode CE1 and the gate electrode GE may be formed by a same process. The first capacitor electrode CE1 and the gate electrode GE may include a conductive metal such as Al, Pt, Pd, Ag, Mg, Au, Ni, Nd, Ir, Cr, Ni, Ca, Mo, Ti, W, and/or Cu. According to some embodiments, the first capacitor electrode CE1 and the gate electrode GE may each have a layer structure including Mo/Al/Mo. According to some embodiments, the first capacitor electrode CE1 and the gate electrode GE may include a TiNx layer, an Al layer, and/or Ti layer.

An interlayer insulating layer 204 may be formed on the first capacitor electrode CE1 and the gate electrode GE. The interlayer insulating layer 204 may include an inorganic insulating material such as silicon nitride, silicon oxide, and/or silicon oxynitride, and may include a single-layer structure or a multi-layer structure including the aforementioned materials.

The second sub-capacitor electrode CE2t may be formed on the interlayer insulating layer 204. The second sub-capacitor electrode CE2t may be electrically connected to the first sub-capacitor electrode CE2b via a contact hole in an insulating layer between the first sub-capacitor electrode CE2b and the second sub-capacitor electrode CE2t. For example, the second sub-capacitor electrode CE2t may contact the first sub-capacitor electrode CE2b via a contact hole through the buffer layer 201, the gate insulating layer 203, and the interlayer insulating layer 204. The first sub-capacitor electrode CE2t may include, for example, a Ti layer, an Al layer, and/or a Cu layer. According to some embodiments, the first sub-capacitor electrode CE2t may include a layer structure including Ti/Al/Ti.

A via insulating layer 205 may be formed on the first pixel circuit PC1, the second pixel circuit PC2, and the third pixel circuit PC3. The via insulating layer 205 may include an inorganic insulating material and/or an organic insulating material. For example, the via insulating layer 205 may include an organic insulating material such as acryl, benzocyclobutene (BCB), polyimide, or hexamethyldisiloxane (HMDSO). The via insulating layer 205 may be formed into a single layer or a multi-layer.

Each of the first pixel circuit PC1, the second pixel circuit PC2, and the third pixel circuit PC3 located on the first substrate 100 may include the transistor TR and the storage capacitor Cst having the structures described above, and may be electrically connected to a pixel electrode of a corresponding light-emitting element.

The pixel electrodes 310 may be arranged apart from one another in a plurality of emission areas (i.e., a first emission area EA1, a second emission area EA2, and a third emission area EA3) (see FIG. 6) above the via insulating layer 205. The pixel electrode 310 may include a reflective film including Ag, Mg, Al, Pt, Pd, Au, Ni, Nd, Ir, Cr, or compounds thereof. The pixel electrode 310 may include a reflective film including the aforementioned materials, and a transparent conductive film located above and/or under the reflective film. The transparent conductive film may include indium tin oxide (ITO), indium zinc oxide (IZO), zinc oxide (ZnO), indium oxide (In₂O₃), indium gallium oxide (IGO), aluminium zinc oxide (AZO), or the like. According to some embodiments, the pixel electrode 310 may have a three-layer structure including ITO/Ag/ITO.

The bank layer 207 may include openings overlapping the pixel electrodes 310 of the first light-emitting element LED1, the second light-emitting element LED2, and the third light-emitting element LED3. The bank layer 207 may cover an edge of the pixel electrode 310 and expose a center portion of the pixel electrode 310 through the opening. The openings of the bank layer 207 may define the first emission area EA1, the second emission area EA2, and the third emission area EA3 (see FIG. 6) of the first light-emitting element LED1, the second light-emitting element LED2, and the third light-emitting element LED3.

The bank layer 207 may include an organic insulating material. For example, the bank layer 207 may include an organic insulating material such as acryl, BCB, polyimide, or HMDSO.

An intermediate layer 320 may be formed on the bank layer 207, and may include an emission layer. The intermediate layer 320 may be integrally formed across the first emission area EA1, the second emission area EA2, and the third emission area EA3. However, according to requirements, the intermediate layer 320 may be patterned to correspond to the first emission area EA1, the second emission area EA2, and the third emission area EA3. In addition to the emission layer, according to requirements, the intermediate layer 320 may further include a hole injection layer, a hole transport layer, an electron transport layer, and/or an electron injection layer. The emission layer included in the intermediate layer 320 may emit light having a wavelength band including a main wavelength of about 450 nm to about 495 nm.

An opposite electrode 330 may be formed on the intermediate layer 320 to cover an entire portion of the display area DA of the first substrate 100. The opposite electrode 330 may include a semi-transmitting electrode or a transmitting electrode. The opposite electrode 330 may include a semi-transmitting electrode, including an ultra-thin film metal including Mg, Ag, Al, Pt, Pd, Au, Ni, Nd, Ir, Cr, or compounds thereof. For example, the opposite electrode 330 may include a semi-transmitting electrode including an MgAg layer, an Yb layer/an MgAg layer, or a Li layer/MgAg layer having a small thickness. According to some embodiments, the opposite electrode 330 may include a transparent conductive oxide such as ITO, IZO, ZnO, In₂O₃, IGO, or AZO.

The pixel electrode 310, the intermediate layer 320, and the opposite electrode 330 overlapping through the openings of the bank layer 207 form a light-emitting element configured to emit blue light. The light-emitting elements are arranged apart from one another, and in this regard, FIG. 5 illustrates the first light-emitting element LED1, the second light-emitting element LED2, and the third light-emitting element LED3. Openings of the bank layer 207 may define emission areas of the light-emitting elements. For example, the opening of the bank layer 207 corresponding to the first light-emitting element LED1 may define the first emission area EA1, the opening of the bank layer 207 corresponding to the second light-emitting element LED2 may define the second emission area EA2, and the opening of the bank layer 207 corresponding to the third light-emitting element LED3 may define the third emission area EA3.

According to some embodiments, the display device DV includes an encapsulation layer 400 formed on the first light-emitting element LED1, the second light-emitting element LED2, and the third light-emitting element LED3. The encapsulation layer 400 may include at least one inorganic encapsulation layer and at least one organic encapsulation layer. According to some embodiments, the encapsulation layer 400 may include a first inorganic encapsulation layer 410, a second inorganic encapsulation layer 430, and an organic encapsulation layer 420 between the first inorganic encapsulation layer 410 and the second inorganic encapsulation layer 430.

The first inorganic encapsulation layer 410 and the second inorganic encapsulation layer 430 may each include at least one inorganic insulating material. The inorganic insulating material may include one or more inorganic insulating materials such as silicon dioxide (SiO₂), silicon nitride (SiNₓ), silicon oxynitride (SiOₓN_{y}), aluminium oxide (Al₂O₃), titanium oxide (TiO₂), tantalum oxide (Ta₂O₅), hafnium oxide (HfO₂), or zinc oxide (ZnO₂), and may be formed by chemical vapor deposition (CVD) and the like.

The organic encapsulation layer 420 may include a polymer-based material. The polymer-based material may include an acrylic resin, an epoxy-based resin, polyimide, polyethylene, and the like. For example, the organic encapsulation layer 420 may include an acrylic resin, for example, polymethylmethacrylate, polyacrylate, and the like. The organic encapsulation layer 420 may be formed by curing a monomer or coating a polymer.

As a thickness of the first inorganic encapsulation layer 410 formed by CVD is approximately uniform, a top surface of the first inorganic encapsulation layer 410 is not flat. However, a top surface of the organic encapsulation layer 420 is approximately flat, and accordingly, a top surface of the second inorganic encapsulation layer 430 on the organic encapsulation layer 420 may also be approximately flat.

Referring to FIG. 6, a light-blocking partition wall 540 may be formed on the encapsulation layer 400. The light-blocking partition wall 540 may surround the emission areas, that is, the first emission area EA1, the second emission area EA2, and the third emission area EA3, and on a plane (on a x-y plane), the light-blocking partition wall 540 may have a net structure.

The light-blocking partition wall 540 may include a colored insulating material. For example, the light-blocking partition wall 540 may include a polyimide (PI)-based binder and a pigment obtained by combination of red, blue, and green. Alternatively, the light-blocking partition wall 540 may include a cardo-based binder resin and a combination of lactam black pigment and blue pigment. Alternatively, the light-blocking partition wall 540 may include carbon black. The light-blocking partition walls 540 may include openings corresponding to the first emission area EA1, the second emission area EA2, and the third emission area EA3.

The light-blocking partition wall 540 may prevent or reduce instances of light, which is converted and scattered by a first color converter 510 and a second color converter 520 to be described later, moving to another area. In addition, the light-blocking partition wall 540, together with a color filter to be described later, may prevent or reduce reflection of external light, thereby improving a contrast ratio of the display device DV.

After forming the light-blocking partition wall 540, the first color converter 510, the second color converter 520, and the transmitter 530 are formed. Materials included in the first color converter 510, the second color converter 520, and the transmitter 530 are the same as described above with reference to FIG. 3. The first color converter 510, the second color converter 520, and the transmitter 530 may be formed in an inkjet method. The first quantum dots 512 and the second quantum dots 522, respectively included in the first color converter 510 and the second color converter 520, may indicate crystals of a semiconductor compound, and may include an arbitrary material capable of emitting light having various emission wavelengths according to crystal sizes. A diameter of the quantum dots may be, for example, from about 1 nm to about 10 nm.

According to some embodiments, each of the first color converter 510, the second color converter 520, the transmitter 530, and the light-blocking partition wall 540 may contact the second inorganic encapsulation layer 430 of the encapsulation layer 400.

The low-refractive inorganic layer 910 and a first passivation layer 920 may be sequentially arranged on the color conversion-transmitting layer 500 (see FIG. 2B). According to some embodiments, the low-refractive inorganic layer 910 may include a low-refraction inorganic material having a refractive index greater than 1.2 and less than 1.4. Generally, the silicon oxide (SiO₂) has a refractive index of from 1.45 to 1.5 that is relatively less than a refractive index of silicon nitride, silicon oxide, or the like. The low-refractive inorganic layer according to embodiments is formed by CVD, and a silicon oxide film having a refractive index less than 1.4 may be formed by changing an amount of a material or deposition conditions during a deposition process. The low-refractive inorganic layer 910 formed by CVD may include an inorganic layer, only including an inorganic material without an organic material.

According to some embodiments, the first color converter 510, the second color converter 520, and the transmitter 530 may have a refractive index of from about 1.7 to about 1.8. Referring to FIG. 3, the first photosensitive polymer 511, the second photosensitive polymer 521, and the third photosensitive polymer 531 may include an organic material having a refractive index of from about 1.5 to about 1.6, and as quantum dots or scattering particles are dispersed in the organic material, the first color converter 510, the second color converter 520, and the transmitter 530 have a refractive index of from about 1.7 to about 1.8, which is greater than the refractive index of the organic material included in the first photosensitive polymer 511, the second photosensitive polymer 521, and the third photosensitive polymer 531. For example, a difference between the refractive indices of each of the first color converter 510, the second color converter 520, and the transmitter 530 and the low-refractive inorganic layer 910 may be 0.3 or greater.

Eventually, when the light is incident on the low-refractive inorganic layer 910 through each of the first color converter 510, the second color converter 520, and the transmitter 530, which are highly refractive, reflection may occur at interfaces between the aforementioned components. In addition, light incident to the low-refractive inorganic layer 910 at least in a certain angle may be totally reflected, and a range in which total reflection occurs may increase according to an increase in the difference between the refractive indices. Due to the low refractive index of the low-refractive inorganic layer 910, a reflectivity of light at a surface of the low-refractive inorganic layer 910 may have a great value. Reflected light may be converted or scattered by the first color converter 510, the second color converter 520, and the transmitter 530 and may be extracted again to outside, and thus, light efficiency of the light may be improved.

According to some embodiments, a thickness of the low-refractive inorganic layer 910 may be from about 100 Å to about 4,000 Å.

The first passivation layer 920 may be located on the low-refractive inorganic layer 910, and the first passivation layer 920 may have a refractive index greater than that of the low-refractive inorganic layer 910. For example, the first passivation layer 920 may include SiON having a refractive index of about 1.6. According to some embodiments, the first passivation layer 920 may include SiO₂ having a refractive index than the refractive index of the low-refractive inorganic layer 910. The first passivation layer 920 may have a thickness of from about 2,000 Å to about 6,000 Å, but is not limited thereto.

According to some embodiments, the first color converter 510, the second color converter 520, the transmitter 530, and the light-blocking partition wall 540 may include an organic material, and the color conversion-transmitting layer 500 (see FIG. 2B) may be covered by the first passivation layer 920 to prevent or reduce permeation into the organic material and the like. As the low-refractive inorganic layer 910 has a low refractive index, a function of permeation prevention of the low-refractive inorganic layer 910 is not very strong, and accordingly, together with the low-refractive inorganic layer 910 for improvement of light-efficiency, the first passivation layer 920 may be additionally arranged.

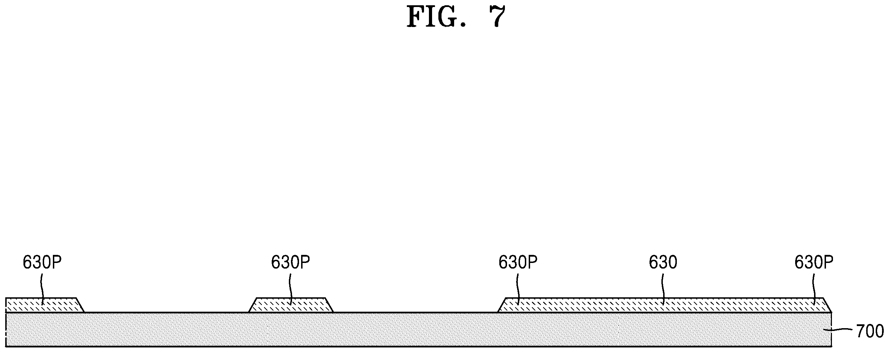

FIGS. 7 to 9 are cross-sectional views of a method of manufacturing a color filter panel, according to some embodiments.

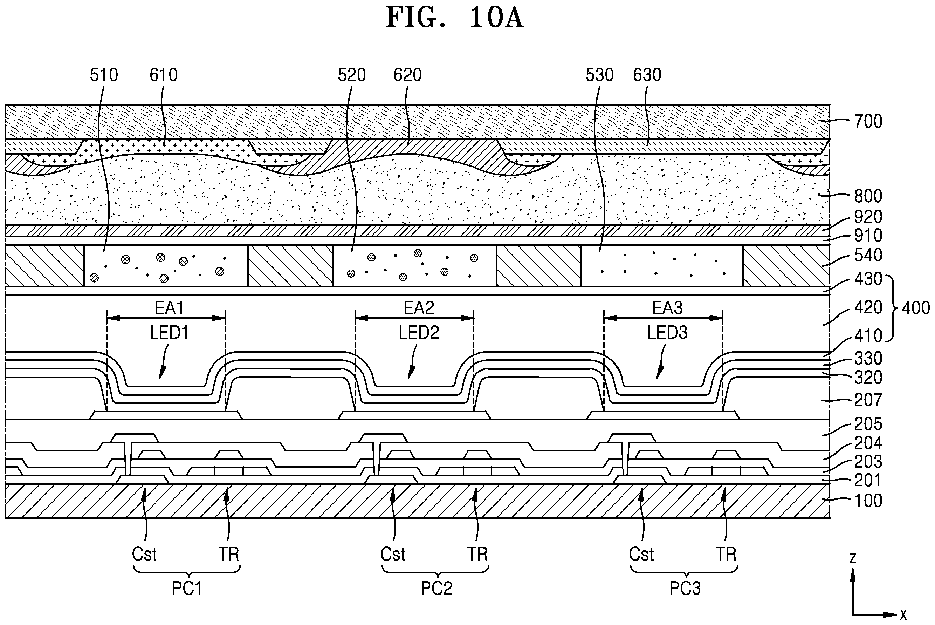

Referring to FIG. 7, the second substrate 700 is provided, and a third color filter 630 configured to transmit light of a third color and a third color layer 630P are formed on the second substrate 700. A portion of the third color layer 630P may be integrally formed with the third color filter 630, and another portion of the third color layer 630P may be formed separate from the third color filter 630. The second substrate 700 may include a glass substrate having SiO₂ as a main component. According to some embodiments, the second substrate 700 may include a polymer resin. Referring to FIG. 10A, after bonding a light-emitting panel and a color filter panel, the third color filter 630 may overlap the third emission area EA3, and the third color filter layer 630P may overlap the light-blocking partition wall 540.

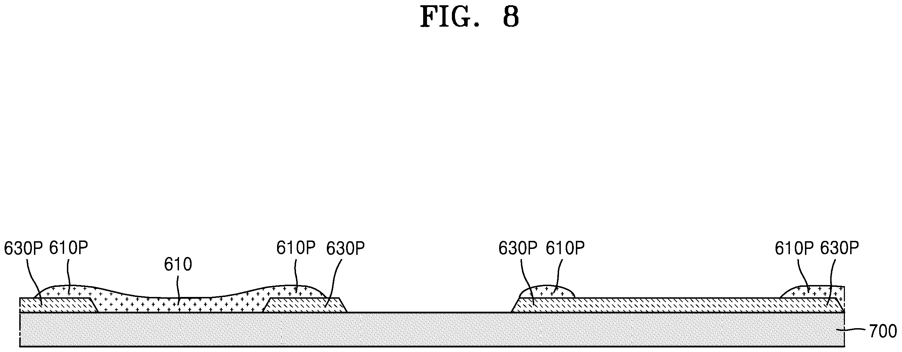

Referring to FIG. 8, after forming the third color filter 630 and the color filter layer 630P, a first color filter 610 and a first color layer 610P configured to emit light of a first color may be formed on the second substrate 700. A portion of the first color layer 610P may be integrally formed with the first color filter 610, and another portion of the first color layer 610P may be formed separate from the first color filter 610. Referring to FIG. 10A, the first color filter 610 may overlap the first emission area EA1, and the first color layer 610P may overlap the light-blocking partition wall 540. In an area of the second substrate 700 overlapping the light-blocking partition wall 540, the third color layer 630P may overlap the first color layer 610P.

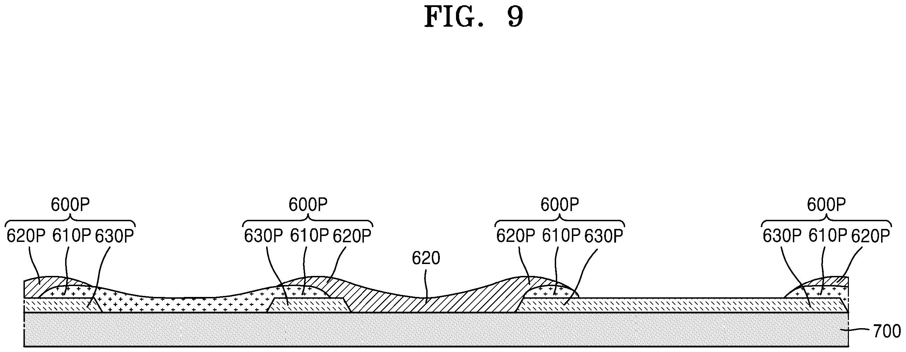

Referring to FIG. 9, after forming the first color filter 610 and the first color layer 610P, a second color filter 620 and a second color layer 620P configured to transmit light of a second color may be formed on the second substrate 700. A portion of the second color layer 620P may be integrally formed with the second color filter 620, and another portion of the second color layer 620P may be formed separate from the second color filter 620. Referring to FIG. 10A, the second color filter 620 may overlap the second emission area EA2, and the second color layer 620P may overlap the light-blocking partition wall 540. In an area of the second substrate 700 overlapping the light-blocking partition wall 540, the third color layer 630P, the first color layer 610P, and the second color layer 620P may be formed in an overlapping manner.

According to some embodiments, the first color, the second color, and the third color may include red, green, and blue, respectively.

For example, as the first color layer 610P that is red, the second color layer 620P that is green, and the third color layer 630P that is blue are arranged in an overlapping manner in a region of the second substrate 700 overlapping the light-blocking partition wall 540, a light-blocking portion 600P dividing the first color filter 610, the second color filter 620, and the third color filter 630 may be implemented. By this configuration, the light-blocking portion 600P may be formed among the color filter as the first color filter 610, the second color filter 620, and the third color filter 630 are formed, without forming an extra layer such as a black matrix having light-blocking function.

Although embodiments in which the third color filter 630, the first color filter 610, and the second color filter 620 are sequentially formed on the second substrate 700 with reference to FIGS. 6 to 9, the first color filter 610, the second color filter 620, and the third color filter 630 may be formed in arbitrary orders.

FIG. 10A is a schematic cross-sectional view of a display device according to some embodiments, formed by bonding the color filter panel and the light-emitting panel respectively shown in FIG. 6 and FIG. 9; and FIG. 10B is a cross-sectional view of a portion of FIG. 10A to describe principles of improvement in light efficiency.

Referring to FIGS. 2A, 2B, and 10A, the light-emitting panel 1000 shown in FIG. 6 and the color filter panel 2000 shown in FIG. 9 are bonded by using the sealant 10. Bonding the light-emitting panel 1000 including the first substrate 100 and the color filter panel 2000 including the second substrate 700 using the sealant 10 does not necessarily indicate that the sealant 10 directly contacts each of the first substrate 100 and the second substrate 700.

After bonding the light-emitting panel 1000 and the color filter panel 2000, a space between the light-emitting panel 1000 and the color filter panel 2000 is filled with the filler 800. For example, the filler 800 may fill a space between the low-refractive inorganic layer 910 and the color filter layer 600, on the color conversion-transmitting layer 500. According to some embodiments, the first passivation layer 920 may be located between the low-refractive inorganic layer 910 and the color filter layer 600 or between the low-refractive inorganic layer 910 and the filler 800. The filler 800 may include a resin such as acryl or epoxy. A thickness of the filler 800 may be from about 1 µm to about 10 µm, and a refractive index of the filler 800 may be from about 1.45 to about 1.55.

When the thickness of the filler 800 is less than 1 µm, it may be difficult to planarize the light-emitting panel 1000 and the color filter panel 2000, and when the thickness of the filler 800 is greater than 10 µm, a thickness of the display device DV may excessively increase.

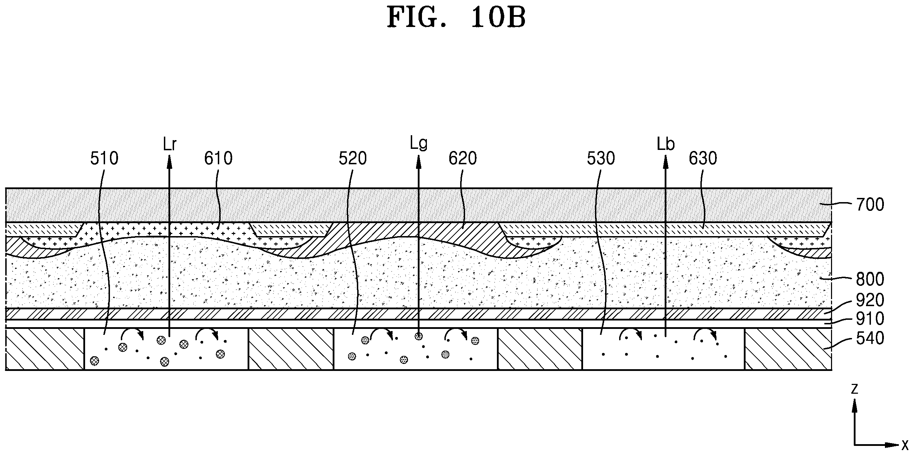

Referring to FIG. 10B, lights emitted from the first light-emitting element LED1, the second light-emitting element LED2, and the third light-emitting element LED3 (see FIG. 2B) and color-converted and/or scattered by the first color converter 510, the second color converter 520, and the transmitter 530 may be reflected from a surface of the low-refractive inorganic layer 910. The first color converter 510, the second color converter 520, and the transmitter 530 may have a refractive index relatively greater than the refractive index of the low-refractive inorganic layer 910, and light incident from a high-refractive layer to a low-refractive layer may be reflected from an interface between the high-refractive layer and the low-refractive layer. The reflectivity may increase according to increase in difference between the refractive indices, and a difference between the refractive indices of the low-refractive inorganic layer 910 and each of the first color converter 510, the second color converter 520, and the transmitter 530 may be about 0.3 or greater.

Reflected light may be re-incident to the first color converter 510, the second color converter 520, and the transmitter 530, and may be color-converted and/or scattered. The possibility that light reflected from the surface of the low-refractive inorganic layer 910 without being color-converted will be re-incident on the first color converter 510, the second color converter 520, and the transmitter 530 and undergo color-conversion by quantum dots may be very high.

According to some embodiments, the low-refractive inorganic layer 910 may be located on the color conversion-transmitting layer 500 to improve light efficiency. In this case, the low-refractive inorganic layer 910 may include an inorganic layer including silicon oxide and the like formed by CVD, instead of an organic material, and a manufacturing cost may be significantly reduced compared with a case in which a low-refractive organic layer is used.

In addition, as the low-refractive inorganic layer 910 is located on the light-emitting panel 1000, not on the color filter panel 2000, a distance between the color conversion-transmitting layer 500 and the low-refractive inorganic layer 910 may be reduced as much as possible, and according to decrease in the distance, loss of light in a path is reduced, and the light efficiency may be further improved.

According to some embodiments, compared with low-refractive organic layers having generally similar refractive indices, the low-refractive inorganic layer 910 may have a lower coefficient of extinction (k). For example, the coefficient of extinction of the low-refraction inorganic layer 910 may be close to zero. When a coefficient of extinction is small, light absorption of a material itself decreases. Accordingly, when the low-refractive inorganic layer 910 is used, compared with an organic layer, loss of light caused due to absorption may be reduced.

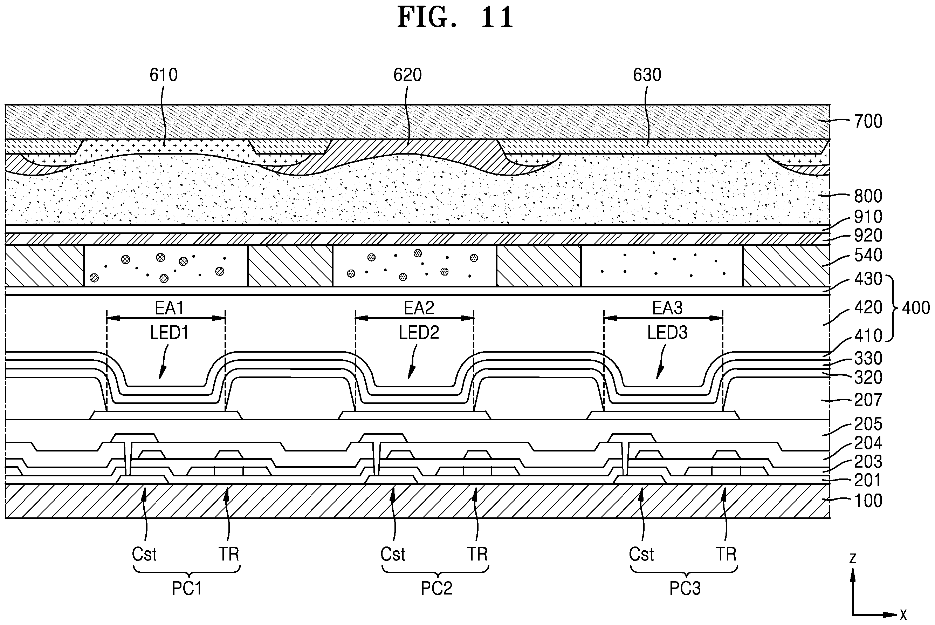

FIG. 11 is a schematic cross-sectional view of a display device according to some embodiments. Hereinafter, differences between the display device shown in FIG. 11 and the display device according to the embodiments shown in FIG. 10A will be mainly described.

Referring to FIGS. 2B and 11, the display device includes: the first substrate 100; the second substrate 700 opposite to the first substrate 100; the light-emitting element layer 300 located on the first substrate 100 and including at least one of the first light-emitting element LED1, the second light-emitting element LED2, or the third light-emitting element LED3; the encapsulation layer 400 located on the light-emitting element layer 300 and including at least one of the inorganic encapsulation layers 410 or 430 (i.e., the first inorganic encapsulation layer 410 and the second inorganic encapsulation layer 430) and at least one organic encapsulation layer 420; the color conversion-transmitting layer 500 located on the encapsulation layer 400 and configured to convert light emitted from at least one of the first light-emitting element LED1, the second light-emitting element LED2, or the third light-emitting element LED3 into light having different colors, the color conversion-transmitting layer 500 including quantum dots; the low-refractive inorganic layer 910 located on the color conversion-transmitting layer 500 and having a refractive index less than a refractive index of the color conversion-transmitting layer 500; the color filter layer 600 located on a surface of the second substrate 700 opposite to the first substrate 100; and the filler 800 located between the low-refractive inorganic layer 910 and the color filter layer 600 and having a refractive index greater than the refractive index of the low-refractive inorganic layer 910.

According to some embodiments, the display device may further include the first passivation layer 920, and the first passivation layer 920 may be located between the color conversion-transmitting layer 500 and the low-refractive inorganic layer 910.

The first passivation layer 920 may have a refractive index greater than the refractive index of the low-refractive inorganic layer 910. For example, the first passivation layer 920 may include SiON having a refractive index of about 1.6. According to some embodiments, the first passivation layer 920 may include SiO₂ having a refractive index greater than the refractive index of the low-refractive inorganic layer 910. The first passivation layer 920 may have a thickness of from about 2,000 Å to about 6,000 Å, but is not limited thereto.

According to some embodiments, the first passivation layer 920 may contact the color conversion-transmitting layer 500 to prevent or reduce permeation and the like into the color conversion-transmitting layer 500.

In addition, as the first passivation layer 920 has the refractive index greater than the refractive index of the low-refractive inorganic layer 910, reflection may easily occur at an interface between the first passivation layer 920 and the low-refractive inorganic layer 910. The light reflected from the low-refractive inorganic layer 910 is re-incident on the color conversion-transmitting layer 500 and undergoes color conversion and/or scattering, and then is extracted to the outside. By repeated reflection and re-incidence, light efficiency of the display device may be improved.

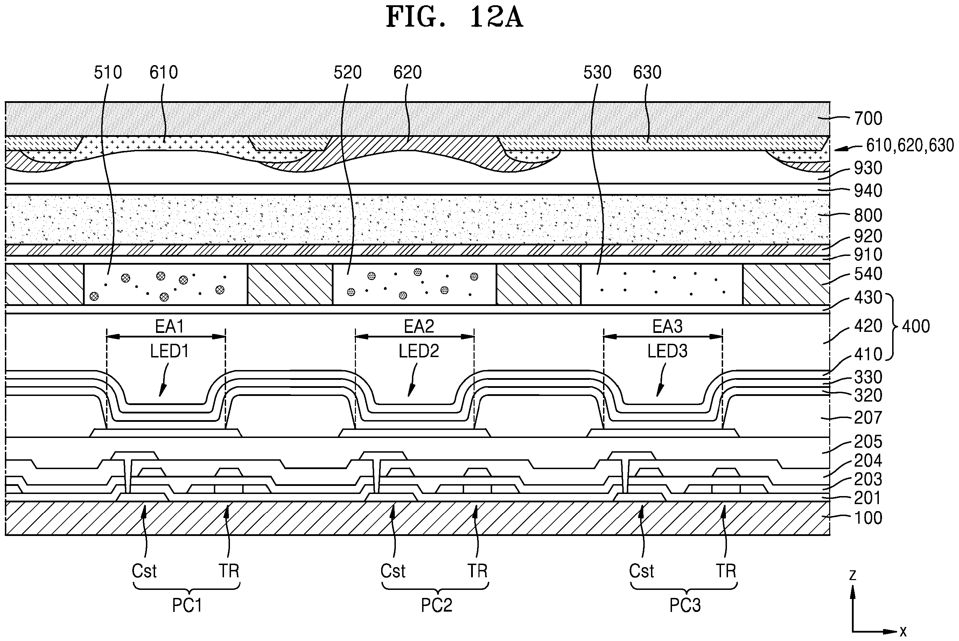

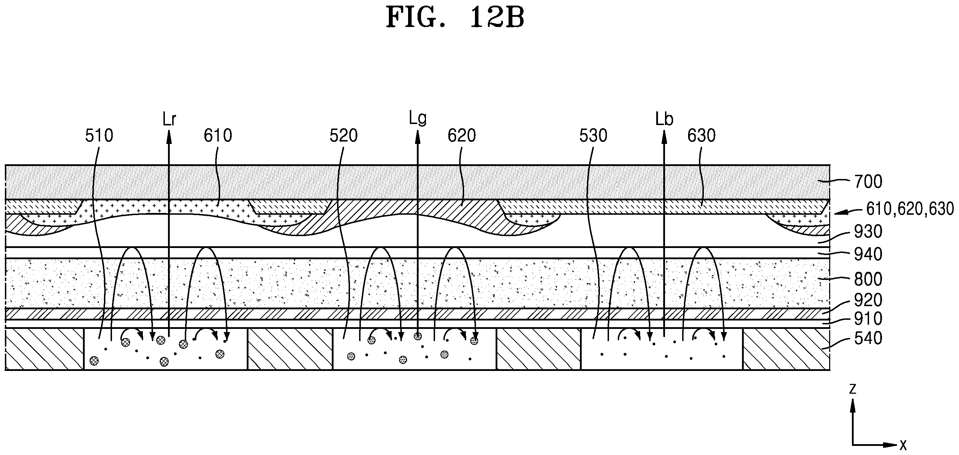

FIG. 12A is a schematic cross-sectional view of a display device according to some embodiments, and FIG. 12B is a cross-sectional view of a portion of FIG. 12A, to describe principles of improvement in light efficiency. Hereinafter, differences from the display device according to the embodiments shown in FIG. 10A will be mainly described.

Referring to FIGS. 2B and 12A, the display device includes: the first substrate 100; the second substrate 700 opposite to the first substrate 100; the light-emitting element layer 300 located on the first substrate 100 and including at least one of the first light-emitting element LED1, the second light-emitting element LED2, or the third light-emitting element LED3; the encapsulation layer 400 located on the light-emitting element layer 300 and including at least one of the inorganic encapsulation layers 410 or 430 (i.e., the first inorganic encapsulation layer 410 or the second inorganic encapsulation layer 430) and at least one organic encapsulation layer 420; the color conversion-transmitting layer 500 located on the encapsulation layer 400 and configured to convert light emitted from at least one of the first light-emitting element LED1, the second light-emitting element LED2, or the third light-emitting element LED3 into light having different colors, the color conversion-transmitting layer 500 including quantum dots; the low-refractive inorganic layer 910 located on the color conversion-transmitting layer 500 and having a refractive index less than a refractive index of the color conversion-transmitting layer 500; the color filter layer 600 located on a surface of the second substrate 700 opposite to the first substrate 100; and the filler 800 located between the low-refractive inorganic layer 910 and the color filter layer 600 and having a refractive index greater than the refractive index of the low-refractive inorganic layer 910.

According to some embodiments, the first passivation layer 920 may be located on the low-refractive inorganic layer 910, and a low-refractive organic layer 930 and a second passivation layer 940 may be located under the color filter layer 600.

The low-refractive organic layer 930 is a layer of which a refractive index is decreased by scattering porous particles such as hollow silica in the organic material, and may have a refractive index of from about 1.2 to about 1.3. According to some embodiments, the low-refractive organic layer 930 may have a refractive index less than the refractive index of the low-refractive inorganic layer 910. In addition to a function of reflecting light from a surface to improve light efficiency, the low-refractive organic layer 930 may also planarize the color filter layer 600.

The second passivation layer 940 may include an inorganic material such as silicon oxynitride or silicon oxide, and may have a refractive index of from about 1.45 to about 1.55. According to some embodiments, both of the second passivation layer 940 and the low-refractive inorganic layer 910 may include silicon oxide, but the refractive index of the second passivation layer 940 may be greater than the low-refractive inorganic layer 910.

The second passivation layer 940 performs a same function as the first passivation layer 920. That is, the second passivation layer 940 protects the first color filter 610, the second color filter 620, and the third color filter 630 from external moisture.

The low-refractive organic layer 930 has the refractive index less than the second passivation layer 940, and the light transmitted through the color conversion-transmitting layer 500 and incident to the low-refractive organic layer 930 via the filler 800 may be reflected from an interface between the low-refractive organic layer 930 and the second passivation layer 940.

Referring to FIG. 12B, as described above with reference to FIG. 10B, the light is reflected from an interface between the color conversion-transmitting layer 500 and the low-refractive inorganic layer 910, and in addition, the light is reflected from the interface between the second passivation layer 940 and the low-refractive organic layer 930 via the filler 800.

Reflected light may be re-incident on the color conversion-transmitting layer 500 via the filler 800, and light that has been re-incident may again undergo color conversion and/or scattering and may then be extracted to the outside. However, as a distance between the color conversion-transmitting layer 500 and the low-refractive organic layer 930 is relatively great, loss of some of the light may occur during movement through light path. In addition, according to some embodiments, a coefficient of extinction (k) of the low-refractive organic layer 930 may be greater than a coefficient of extinction of the low-refractive inorganic layer 910.

The display device according to the embodiments shown in FIG. 12A further includes the low-refractive organic layer 930 in addition to the low-refractive inorganic layer 910, and by improving utility of light by refraction and re-incidence, light efficiency may be further improved.

Although the embodiments shown in FIG. 12A illustrate a case in which the first passivation layer 920 is located on the low-refractive inorganic layer 910, according to some embodiments, the embodiments shown in FIG. 12A may also be applied to a case in which the first passivation layer 920 and the low-refractive inorganic layer 910 are sequentially stacked on the color conversion-transmitting layer 500, like the embodiments shown in FIG. 11.

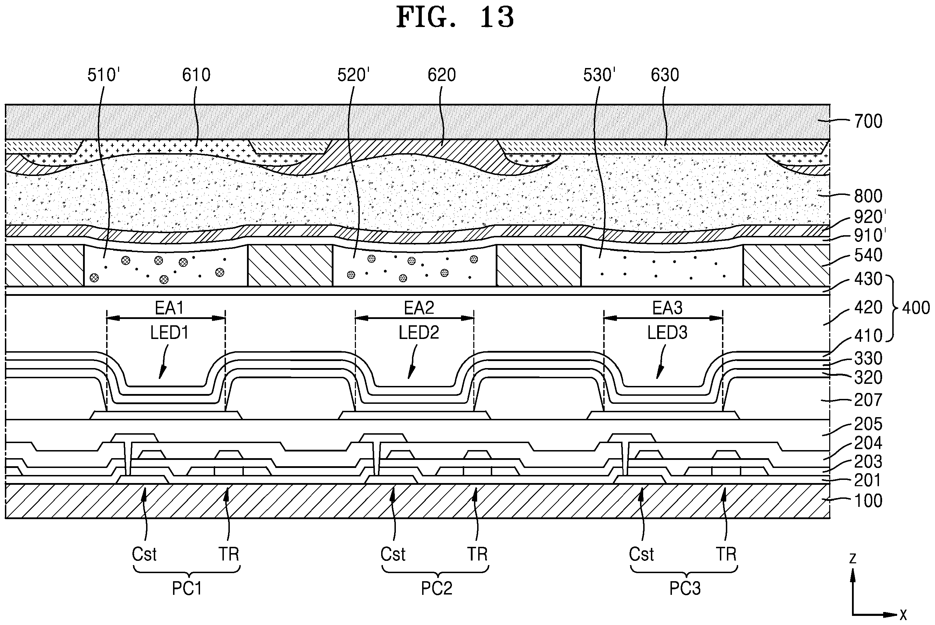

FIG. 13 is a schematic cross-sectional view of a display device according to some embodiments.

Referring to FIGS. 2B and 13, the display device includes: the first substrate 100; the second substrate 700 opposite to the first substrate 100; the light-emitting element layer 300 located on the first substrate 100 and including at least one of the first light-emitting element LED1, the second light-emitting element LED2, or the third light-emitting element LED3; the encapsulation layer 400 located on the light-emitting element layer 300 and including at least one of the inorganic encapsulation layers 410 or 430 (i.e., the first inorganic encapsulation layer 410 or the second inorganic encapsulation layer 430) and at least one organic encapsulation layer 420; color conversion-transmitting layers 510', 520', 530', or 540' located on the encapsulation layer 400 and configured to convert light emitted from at least one of the first light-emitting element LED1, the second light-emitting element LED2, or the third light-emitting element LED3 into light having different colors, the color conversion-transmitting layers 510', 520', 530', and 540' including quantum dots; the low-refractive inorganic layer 910 located on the color conversion-transmitting layers 510', 520', 530', and 540' and having a refractive index less than refractive indices of the color conversion-transmitting layers 510', 520', 530', and 540'; the color filter layer 600 located on a surface of the second substrate 700 opposite to the first substrate 100; and the filler 800 located between the low-refractive inorganic layer 910' and the color filter layer 600 and having a refractive index greater than the refractive index of the low-refractive inorganic layer 910'.

According to some embodiments, the light-blocking partition wall 540 may be formed on the second inorganic encapsulation layer 430. The light-blocking partition wall 540 may surround the emission areas, that is, the first emission area EA1, the second emission area EA2, and the third emission area EA3 (see FIG. 6), and on a plane (on a x-y plane), the light-blocking partition wall 540 may have a net structure.

The light-blocking partition wall 540 may include a colored insulating material. For example, the light-blocking partition wall 540 may include a polyimide (PI)-based binder and a pigment obtained by a combination of red, blue, and green. Alternatively, the light-blocking partition wall 540 may include a cardo-based binder resin and a combination of lactam black pigment and blue pigment. Alternatively, the light-blocking partition wall 540 may include carbon black. The light-blocking partition walls 540 may include openings respectively corresponding to the first emission area EA1, the second emission area EA2, and the third emission area EA3.

The light-blocking partition wall 540 may prevent or reduce light converted and scattered by a first color converter 510 and a second color converter 520 to be described later from moving to another area. In addition, the light-blocking partition wall 540 may prevent or reduce reflection of external light with a color filter to be described later, thereby improving a contrast ratio of the display device DV.

After forming the light-blocking partition wall 540, a first color converter 510' a second color converter 520', and a transmitter 530' are formed. Materials included in the first color converter 510', the second color converter 520', and the transmitter 530' are the same as described above with reference to FIG. 3. The first color converter 510', the second color converter 520', and the transmitter 530' may each be formed in an inkjet method. According to some embodiments, the first color converter 510', the second color converter 520', and the transmitter 530' may have a shape recessed with respect to a top surface of the light-blocking partition wall 540. This may be caused by shrink of ink during a manufacturing process.

The low-refractive inorganic layer 910' and the first passivation layer 920' may be sequentially arranged on the color conversion-transmitting layer 500 (see FIG. 2B). According to some embodiments, the low-refractive inorganic layer 910' may include a low-refractive inorganic material having a refractive index greater than 1.2 and less than 1.4. Generally, the silicon oxide (SiO₂) has a refractive index of from 1.45 to 1.5 that is relatively lower than a refractive index of silicon nitride, silicon oxide, or the like. The low-refractive inorganic layer 910' is formed by CVD, and a silicon oxide film having a refractive index less than 1.4 may be formed by changing an amount of a material or deposition conditions during a deposition process.

According to some embodiments, the first color converter 510', the second color converter 520', and the transmitter 530' may have a refractive index of from about 1.7 to about 1.8, and for example, difference in refractive indices between each of the first color converter 510', the second color converter 520', and the transmitter 530' and the low-refractive inorganic layer 910' may be at least 0.3.

According to some embodiments, a thickness of the low-refractive inorganic layer 910' may be from about 100 Å to about 4000 Å. As the low-refractive inorganic layer 910' is generally formed in a substantially uniform thickness, a top surface of the low-refractive inorganic layer 910' is not flat and may have grooves corresponding to concave shapes of the first color converter 510', the second color converter 520', and the transmitter 530'.

The first passivation layer 920' may be located on the low-refractive inorganic layer 910', and the first passivation layer 920' may have a refractive index greater than a refractive index of the low-refractive inorganic layer 910'. For example, the first passivation layer 920' may include SiON having a refractive index of about 1.6. According to some embodiments, the first passivation layer 920' may include silicon oxide (SiOₓ) having a refractive index greater than the refractive index of the low-refractive inorganic layer 910'. The first passivation layer 920' may have a thickness of from about 2000 Å to about 6000 Å, but is not limited thereto.

As the first passivation layer 920' is generally formed in a substantially uniform thickness, a top surface of the first passivation layer 920' is not flat and may have a shape corresponding to the recessed shapes of the first color converter 510', the second color converter 520', and the transmitter 530'. That is, a surface of the light-emitting panel 1000 opposite to the color filter panel 2000 may be not flat.

Although FIG. 13 illustrates embodiments in which the low-refractive inorganic layer 910' and the first passivation layer 920' are sequentially arranged on the color conversion-transmitting layer 500 (see FIG. 2B), according to some embodiments, the first passivation layer 920 and the low-refractive inorganic layer 910 may be sequentially arranged on the color conversion-transmitting layer 500 (see FIG. 2B), like in the embodiments shown in FIG. 11, and in this case, top surfaces of the first passivation layer 920 and the low-refractive inorganic layer 910 may be not flat. In addition, the embodiments shown in FIG. 13 may also be applied to the case in which the first passivation layer 920 is located on the low-refractive inorganic layer 910 and the low-refractive organic layer 930 and the second passivation layer 940 are located under the color filter layer 600, like in the embodiments shown in FIG. 12A. In this case, the top surfaces of the first passivation layer 920 and the low-refractive inorganic layer 910 may be not flat.

Table 1 shows simulation results for light efficiency and reflectivity of external light of the display device of FIG. 10A according to an embodiments in comparison with a comparative example when a thickness of the filler is 5 µm. The comparative example relates to a display device in which only the first passivation layer 920 is located on the color conversion-transmitting layer 500 without the low-refractive inorganic layer 910, and the low-refractive organic layer 930 and the second passivation layer 940 are located under the color filter layer 600.

Referring to Table 1, it is illustrated that the light efficiency of the display device according to some embodiments increased by 9% with reference to white light. To exclude an increase of the light efficiency caused by reflectivity of external light, a result of a case in which the reflectivity of external light is same is also obtained, and in this case, it is obvious that the light efficiency increased by 4% with reference to white light. Here, SCI indicates a reflectivity including both of scattering reflection and mirror reflection, and SCE indicates a reflectivity only including scattering reflection.

**Table 1**

| Filler (5 *µ*m) | efficiency | | | | reflectivity | |
|---|---|---|---|---|---|---|
| | R | G | B | W | SCI | SCE |
| comparative embodiment | 100 | 100 | 100 | 100 | 1.18% | 0.77% |
| embodiments of the present disclosure (FIG. 10A) | 111% | 109% | 105% | 109% | 1.26% | 0.85% |
| | with reference to same reflectivity | | | 104% | 1.18% | 0.77% |

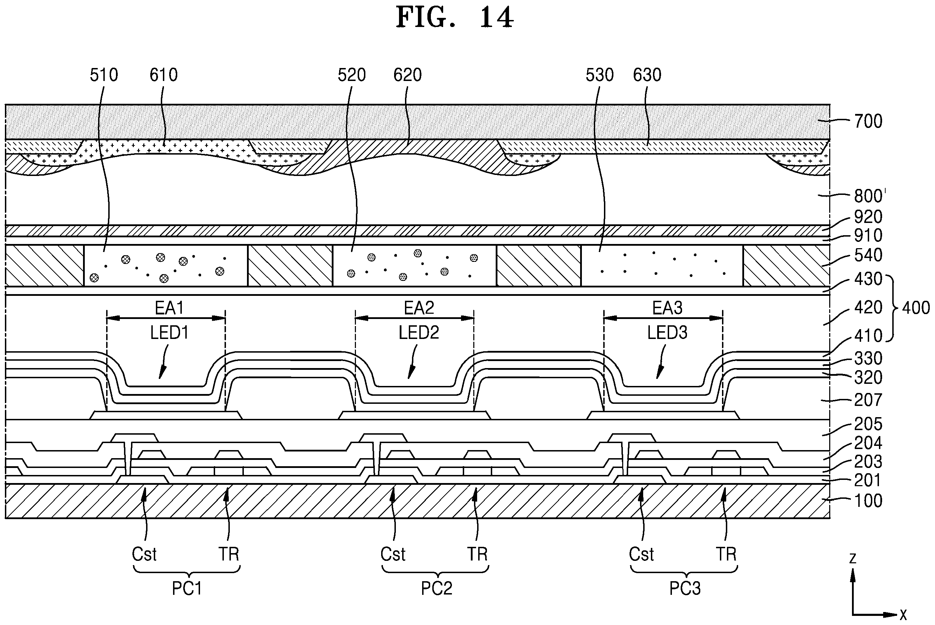

FIG. 14 is a schematic cross-sectional view of a display device according to some embodiments.

Referring to FIGS. 2B and 14, the display device includes: the first substrate 100; the second substrate 700 opposite to the first substrate 100; the light-emitting element layer 300 located on the first substrate 100 and including at least one of the first light-emitting element LED1, the second light-emitting element LED2, or the third light-emitting element LED3; the encapsulation layer 400 located on the light-emitting element layer 300 and including at least one of the inorganic encapsulation layers 410 or 430 (i.e., the first inorganic encapsulation layer 410 or the second inorganic encapsulation layer 430) and at least one organic encapsulation layer 420; the color conversion-transmitting layer 500 located on the encapsulation layer 400 and configured to convert light emitted from at least one of the first light-emitting element LED1, the second light-emitting element LED2, or the third light-emitting element LED3 into light having other colors, the color conversion-transmitting layer 500 including quantum dots; the low-refractive inorganic layer 910 located on the color conversion-transmitting layer 500 and having a refractive index less than a refractive index of the color conversion-transmitting layer 500; the color filter layer 600 located on a surface of the second substrate 700 opposite to the first substrate 100, and being apart from the low-refractive inorganic layer 910 with an air gap 800' therebetween.

According to some embodiments, as the air gap 800' may be naturally formed during a bonding process, there is no requirements for an extra filler or filling process, and thus may be economic. In addition, the air gap 800' may be filled with a gas from which oxygen or a gas containing certain components may be removed or to which a gas containing certain components is added, including general air.

According to some embodiments, the refractive index of the low-refractive inorganic layer 910 may be greater than 1.2 and less than 1.4, and the thickness of the low-refractive inorganic layer 910 may be from about 100 Å to about 4000 Å. The low-refractive inorganic layer 910 may be formed by CVD, and may form a silicon oxide film having a refractive index less than 1.4 by changing a content of materials or deposition conditions during a deposition process. The low-refractive inorganic layer 910 formed by CVD may include an inorganic layer, only including an inorganic material without an organic material.

The difference between the refractive index of the color conversion-transmitting layer 500 and the refractive index of the low-refractive inorganic layer 910 may be 0.3 or greater, and the light efficiency may be improved by reflection from an interface between the color conversion-transmitting layer 500 and the low-refractive inorganic layer 910.

The color filter layer 600 may include the first color filter 610 configured to transmit the light having the first color filter 610, the second color filter 620 configured to transmit the light having the second color, the third color filter 630 configured to transmit the light having the third color, and the light-blocking portion 600P (see FIG. 9), and the light-blocking portion 600P may be formed by overlapping the first color layer 610P, the second color layer 620P, and the third color layer 630P respectively including same materials with the first color filter 610, the second color filter 620, and the third color filter 630.

Although FIG. 14 illustrates that each of the first color converter 510, the second color converter 520, and the third color converter 530 has a flat top surface, the first color converter 510, the second color converter 520, and the transmitter 530 may each have a concave shape recessed with respect to the top surface of the light-blocking partition wall 540, as shown in FIG. 13. In this case, the low-refractive inorganic layer 910 may also include a groove formed according to the concave shape.

Although FIG. 14 illustrates embodiments in which the low-refractive inorganic layer 910 and the first passivation layer 920 are sequentially arranged on the color conversion-transmitting layer 500 (see FIG. 2B) and the air gap 800' directly contacts the low-refractive inorganic layer 910, according to some embodiments, the first passivation layer 920 and the low-refractive inorganic layer 910 may be sequentially arranged on the color conversion-transmitting layer 500 (see FIG. 2B), like in the embodiments shown in FIG. 11. In this case, the air gap 800' may directly contact the first passivation layer 920. The first passivation layer 920 may have the refractive index greater than the refractive index of the low-refractive inorganic layer 910, and for example, may include silicon oxynitride (SiON) having a refractive index of about 1.6. According to some embodiments, the first passivation layer 920 may include SiO₂ having a refractive index than the refractive index of the low-refractive inorganic layer 910. The first passivation layer 920 may have a thickness of from about 2000 Å to about 6000 Å, but is not limited thereto.

According to some embodiments, the air gap 800' may also be applied in embodiments in which the first passivation layer 920 is located on the low-refractive inorganic layer 910 and the low-refractive organic layer 930 and the second passivation layer 940 is located under the color filter layer 600, like the embodiments shown in FIG. 12A. In this case, the air gap 800' may be located between the first passivation layer 920 and the second passivation layer 940.

According to the embodiments described above, the light-emitting panel 1000 includes the color conversion-transmitting layer 500 and the low-refractive inorganic layer 910 on the color conversion-transmitting layer 500, the light is reflected from the surface between the color conversion-transmitting layer 500 and the low-refractive inorganic layer and re-incident to the color conversion-transmitting layer 500, and therefore, the light efficiency may be improved.

The low-refractive inorganic layer 910 is included in the light-emitting panel 1000 and contacts the color conversion-transmitting layer 500 or is arranged adjacent to the color conversion-transmitting layer 500, and therefore, loss of the light from the color conversion-transmitting layer 500 before arriving the low-refractive inorganic layer 910 may be reduced as much as possible.

The low-refractive inorganic layer 910 has a coefficient of extinction lower than the coefficient of extinction of the low-refractive organic layer 930, and a cost for materials of the low-refractive inorganic layer 910 is much lower than that of the low-refractive organic layer 930, and therefore, may be advantageous in terms of cost compared with a configuration including the low-refractive organic layer 930.

According to some embodiments, the display device DV may further include the low-refractive organic layer 930 configured to planarize the color filter layer 600 and having a low refractive index, in addition to the low-refractive inorganic layer 910. When the display device DV further includes the low-refractive organic layer 930, a manufacturing cost may increase, while the light efficiency may be further improved.

Although the invention has been described with reference to the illustrated embodiments, it should be understood that this is merely exemplary, and those of ordinary skill in the art will appreciate that various modifications and equivalent other embodiments are possible. Therefore, the true technical scope of the invention should be determined by the technical spirit of the appended claims.

## Claims

1. A display device comprising:
a first substrate;
a second substrate opposite to the first substrate;
a light-emitting element layer on the first substrate and comprising at least one light-emitting element;
an encapsulation layer on the light-emitting element layer and comprising at least one inorganic encapsulation layer and at least one organic encapsulation layer;
a color conversion-transmitting layer on the encapsulation layer and configured to convert light emitted from the at least one light-emitting element into light having different colors, the color conversion-transmitting layer including quantum dots;
a low-refractive inorganic layer on the color conversion-transmitting layer and having a refractive index less than a refractive index of the color conversion-transmitting layer;
a color filter layer on a surface of the second substrate opposite to the first substrate; and
a filler between the low-refractive inorganic layer and the color filter layer and having a refractive index greater than the refractive index of the low-refractive inorganic layer.

2. The display device of claim 1, wherein the refractive index of the low-refractive inorganic layer is greater than 1.2 and less than 1.4.

3. The display device of claim 2, wherein the low-refractive inorganic layer comprises silicon oxide (SiO₂).

4. The display device of claim 1, wherein a thickness of the low-refractive inorganic layer is from 100 Å to 4,000 Å.

5. The display device of claim 1, a difference between the refractive index of the color conversion-transmitting layer and the refractive index of the low-refractive inorganic layer is at least 0.3.

6. The display device of claim 1, further comprising a first passivation layer between the color conversion-transmitting layer and the filler, the first passivation layer having a refractive index greater than the refractive index of the low-refractive inorganic layer.

7. The display device of claim 6, wherein the first passivation layer is between the low-refractive inorganic layer and the filler.

8. The display device of claim 6, wherein the first passivation layer is between the color conversion-transmitting layer and the low-refractive inorganic layer.

9. The display device of claim 6, wherein the first passivation layer comprises an inorganic material layer comprising silicon oxynitride (SiON).

10. The display device of claim 1, wherein the refractive index of the filler is from 1.45 to 1.55, and a thickness of the filler is from 1 µm to 10 µm.

11. The display device of claim 1,
wherein the encapsulation layer comprises a first inorganic encapsulation layer, an organic encapsulation layer, and a second inorganic encapsulation layer sequentially arranged, and
the color conversion-transmitting layer directly contacts the second inorganic encapsulation layer.

12. The display device of claim 1,
further comprising a low-refractive organic layer and a second passivation layer on a surface of the color filter layer opposite to the color conversion-transmitting layer.

13. The display device of claim 12, wherein the low-refractive organic layer comprises an organic material and porous particles dispersed in the organic material.

14. The display device of claim 12, wherein the low-refractive inorganic layer has a coefficient of extinction less than a coefficient of extinction of the low-refractive organic layer.

15. The display device of claim 12, wherein a refractive index of the low-refractive organic layer is less than the refractive index of the low-refractive inorganic layer.

16. The display device of claim 12, wherein the second passivation layer comprises an inorganic material layer comprising SiO₂ and has a refractive index greater than the refractive index of the low-refractive inorganic layer.

17. The display device of claim 1,
wherein the color filter layer comprises a first color filter configured to transmit light of a first color, a second color filter configured to transmit light of a second color, a third color filter configured to transmit light of a third color, and a light-blocking portion dividing the first color filter, the second color filter, and the third color filter, and
in the light-blocking portion, a first color layer, a second color layer, and a third color layer respectively comprising same materials as the first color filter, the second color filter, and the third color filter overlap.

18. The display device of claim 1,
wherein the light-emitting element layer comprises a first light-emitting element, a second light-emitting element, and a third light-emitting element, and
the color conversion-transmitting layer comprises a first color converter corresponding to the first light-emitting element, a second color converter corresponding to the second light-emitting element, and a transmitter corresponding to the third light-emitting element,
and further comprises a light-blocking partition wall arranged among the first color converter, the second color converter, and the transmitter.

19. The display device of claim 18,
wherein a top surface of each of the first color converter, the second color converter, and the transmitter has a concave shape recessed with respect to a top surface of the light-blocking partition wall, and
the low-refractive inorganic layer comprises a groove formed according to the concave shape.

20. The display device of claim 1, wherein the first substrate and the second substrate each comprises glass.

21. A display device comprising:
a first substrate;
a second substrate opposite to the first substrate;
a light-emitting element layer on the first substrate and comprising at least one light-emitting element;
an encapsulation layer on the light-emitting element layer and comprising at least one inorganic encapsulation layer and at least one organic encapsulation layer;
a color conversion-transmitting layer on the encapsulation layer and configured to convert light emitted from the at least one light-emitting element into light having different colors, the color conversion-transmitting layer including quantum dots;
a low-refractive inorganic layer on the color conversion-transmitting layer and having a refractive index less than a refractive index of the color conversion-transmitting layer; and
a color filter layer on a surface of the second substrate opposite to the first substrate, and being spaced apart from the low-refractive inorganic layer with an air gap therebetween.

22. The display device of claim 21,
wherein the refractive index of the low-refractive inorganic layer is greater than 1.2 and less than 1.4, and
a thickness of the low-refractive inorganic layer is from 100 Å to 4,000 Å.

23. The display device of claim 21, a difference between the refractive index of the color conversion-transmitting layer and the refractive index of the low-refractive inorganic layer is at least 0.3.

24. The display device of claim 21,
wherein the color filter layer comprises a first color filter configured to transmit light of a first color, a second color filter configured to transmit light of a second color, a third color filter configured to transmit light of a third color, and a light-blocking portion dividing the first color filter, the second color filter, and the third color filter, and
in the light-blocking portion, a first color layer, a second color layer, and a third color layer respectively comprising same materials as the first color filter, the second color filter, and the third color filter overlap.

25. The display device of claim 21,
wherein the light-emitting element layer comprises a first light-emitting element, a second light-emitting element, and a third light-emitting element, and the color conversion-transmitting layer comprises a first color converter corresponding to the first light-emitting element, a second color converter corresponding to the second light-emitting element, and a transmitter corresponding to the third light-emitting element, and further comprises a light-blocking partition wall arranged among the first color converter, the second color converter, and the transmitter, wherein a top surface of each of the first color converter, the second color converter, and the transmitter has a concave shape recessed with respect to a top surface of the light-blocking partition wall, and
the low-refractive inorganic layer comprises a groove formed according to the concave shape.
